(19) Europäisches Patentamt
European Patent Office
Office européen des brevets

(11) **EP 3 301 460 A1**

(12) **EUROPEAN PATENT APPLICATION**

(43) Date of publication:
**04.04.2018 Bulletin 2018/14**

(51) Int Cl.:
**G01R 19/165** (2006.01)   **G01R 31/02** (2006.01)
**G01R 31/08** (2006.01)   G01R 31/327 (2006.01)
H02H 3/08 (2006.01)   H02H 7/26 (2006.01)
H02H 11/00 (2006.01)

(21) Application number: **16460073.6**

(22) Date of filing: **30.09.2016**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **ABB Schweiz AG**
**5400 Baden (CH)**

(72) Inventors:
• **Krysztofiak, Piotr**
  **96-200 Rawa Mazowiecka (PL)**

• **Koska, Krzysztof**
  **31-960 Krakow (PL)**
• **Piasecki, Wojciech**
  **31-347 Krakow (PL)**
• **Ruszczyk, Adam**
  **30-316 Krakow (PL)**

(74) Representative: **Chochorowska-Winiarska,
Krystyna**
**ABB Sp. z o. o.**
**ul. Zeganska 1**
**04-713 Warszawa (PL)**

(54) **A CATENARY LINE TEST DEVICE FOR A MAIN CIRCUIT BREAKER OF AN AC CATENARY LINE SYSTEM**

(57)   The subject of the invention is a catenary line test device (7) for a main circuit breaker (6) of an AC catenary line system (1). The invention is used for detection of short circuit in AC catenary line system (1) prior to closing, the main circuit breaker (6). The catenary line system (1) is powered by through connecting terminals first (4) and second (5) and the main circuit breaker (6) is connected to the overhead line (2) and a load (8) is connected between the overhead line (2) and a return grounding line (3). The catenary line test device (7) is adapted to prevent of closing the main circuit breaker (6) on short-circuited overhead line (2), and the test device (7) comprises a capacitor circuit (103) and an impulse generator circuit (104) connected in series. To the capacitor circuit (103) a measuring and control circuit (105) is connected for providing a half period of an electrical impulse generated in the impulse generator circuit (104), causes the flow of the supply current into the catenary line system (1) through the first connecting terminal (4).

Fig 1

# Description

The subject of the invention is a catenary line test device for a main circuit breaker of an AC catenary line system. The invention is used for detection of short circuit in AC catenary line system prior to closing the main circuit breaker.

The commonly known line test device for checking the presence of short circuit in the AC catenary line system consists circuit breaker to handle making and breaking operations and in series connected test resistance. The purpose of series connected resistance is the limitation of the test current. The line test device is connected in parallel to the main circuit breaker of the AC catenary line system. The line test device closes for the short period of time and energize AC catenary line system. The voltage in the catenary line in reference to the earth is measured and if the voltage is above 2kV the line is regarded healthy. The disadvantage of this method is relative big amounts of energy released in the test resistance in case of short circuit. The second disadvantage is problems to distinguishing the heavy loaded line from the faulty line. Heavy loaded line will have big inrush current, which sometimes is hard to distinguish from short circuit current.

There is known from patent EP1855120 a device for evaluating line tests of outgoing power line. The claimed solution makes it possible to determine with a high degree of certainty whether there is a short-circuit or not on the AC catenary line. The device comprises a main breaker connected between a busbar for feeding an alternating voltage and a contact wire, which represents the catenary line. The main breaker is connected in parallel with a test resistance and a test breaker for energizing the test resistance with the alternation voltage from the busbar. The device is adapted to record the voltage between the contact line and earth during the energizing and based on the recorded voltage determine at least one characteristic for the shape of the voltage curve and base on the determined characteristic, determine whether the power line is short-circuited or not. By evaluating the shape of the recorded voltage curve it is possible to distinguish a short-circuit from an electric load connected to the line, such as a transformer or electric engine. The unsolved issue is the need of usage of the limiting resistor with very high peak power rating during the test procedure period.

The disadvantage of all methods using the test resistance, which is limiting magnitude of the current in the line, is limited ability to clear temporary short circuits. i.e. when fallen down branch of a tree makes short circuit it looks like persistent fault. However if large current will flow through this branch the persistent fault may change into a transient fault. Test resistance will always limit the ability to self-clearing of such short circuits.

The essence of a catenary line test device for a main circuit breaker of an AC catenary line system, powered by through connection terminals first and second, where the main circuit breaker is connected to the overhead line and a load is connected between the overhead line and a return grounding line, and to the main circuit breaker the test device is parallel connected; the catenary line test device is adapted to prevent of closing the main circuit breaker on short-circuited overhead line, is that the test device comprises a capacitor circuit and an impulse generator circuit connected in series. To the capacitor circuit a measuring and control circuit is connected for providing a half period of an electrical impulse generated in the impulse generator circuit, causes the flow of the supply current into the catenary line system through the first terminal.

Preferably the measuring and control circuit is connected in parallel with the capacitor circuit and the capacitor circuit comprises at least one capacitor or capacitor banks having the value C, calculated according to the formula:

$$C = \frac{2W}{U^2}$$

where:

W -is a maximum energy entering to the catenary line system from the external mains,

U - is a magnitude of AC voltage between terminals of the external mains.

Alternatively the measuring and control circuit is connected in parallel between the overhead line and the ground line in such a way that the test device has an electrical connection with the second connection terminal of the external mains; the capacitor circuit comprises a capacitor or capacitor banks as a main element for limiting the current entering the catenary line system having the capacitance of a value C', calculated according to the formula:

$$C' = \frac{I}{2\pi f U}$$

where:

I - is a value of current entering the catenary line system from the external mains,
U - is a magnitude of AC voltage between terminals of the external mains,
f - is a frequency of the external mains.

Preferably the impulse generator circuit is equipped with solid-state means for generating a half period long electrical impulse having at least one thyristor.
The advantages of the invention in comparison with a solutions using a test resistance connected in series with a test circuit breaker, is that the invention is more reliable. In case of short circuit of the catenary line system, the current is switched off immediately after reaching the limit of Joule's integral. The catenary line test device according to the invention in comparison with the solution using the test resistance is not limiting the magnitude of inrush current, thus the ability of self-clearing in case of transient short circuit is saved.

The invention is presented in the drawing in an exemplary embodiment where:

　　　fig. 1 - presents a scheme of a catenary line system,

　　　fig. 2 - presents a block diagram of the test device from fig. 1 in the first embodiment,

　　　fig. 3 - presents a block diagram of the test device from fig. 1 in the second embodiment,

　　　fig. 4 - presents diagrams of waveforms during the test of the faulty line according to the first embodiment,

　　　fig. 5 - presents diagrams of waveforms during the test of the healthy line according to the first embodiment,

　　　fig. 6 - presents diagrams of waveforms during the test of the faulty line according to the second embodiment,

　　　fig. 7 - presents diagrams of waveforms during the test of the healthy line according to the second embodiment.

A catenary line 1 system is divided into many sections and each of the section comprises two lines, the first overhead line 2 and the second return grounding line 3 situated parallel. The overhead line 2 is powered from an external mains, not presented in the drawing, having two connecting terminals, the first one 4 is connecting the overhead line 2, and the second one 5 is connecting the return line 3. The both connecting terminals 4 and 5 of the mains belongs to a substation power system, what is not presented in the drawing. The substation power system is powering the catenary overhead line 2 through a main circuit breaker 6. The main circuit breaker 6 is connected in parallel with a test device 7. To the catenary line 1 system a load 8 is connected, where the load 8 represents electric locomotive circuit. The load 8 is connected with the return line 3. The load 8 is connected with the return line 3 through rails not presented in the drawing. The possible short-circuit is indicated in the drawing as an arrow between the overhead line 2 and the return line 3. Test device 7 is connected with the circuit breaker 6 by two terminals 101 and 102. Between the two terminals 101 and 102 a capacitor circuit 103 and an impulse generator circuit 104 are connected in series. The capacitor circuit 103 is connected with a measuring and control circuit 105 having a connection with impulse generator circuit 104.

In the first embodiment of the invention the measuring and control circuit 105 is connected in parallel to the capacitor circuit 103 and designed for limiting the Joule's integral of generated impulse to particular level. The capacitor circuit 103 comprises of a capacitor as a main element for limiting the Joule's integral of generated impulse to particular level. The capacitor circuit 103 comprises at least one capacitor or capacitor banks having the capacitance of a value C, calculated according to the formula:

$$C = \frac{2W}{U^2} \qquad (1)$$

where:

　　　W -is a maximum energy entering to the catenary line system (1) from the external mains,

　　　U - is a magnitude of AC voltage between connecting terminals (4) and (5).

The capacitor circuit 103 of the test device 7 is not limiting the magnitude of inrush current, thus the ability of self-clearing in case of transient short circuit is saved. The impulse generator circuit 104 is designed for enabling to flow the current into the catenary line system 1 for only a half of the period of an electrical impulse. The circuit 104 comprises solid-state means for enabling the current for flowing into the catenary line 1 for only the half of the period, such as a thyristor as a main element for carried out the function. The measuring and control circuit 105 is designed for detecting if the joule integral of generated impulse has reached the maximum allowable level. The both circuits 103 and 104 comprise many electronic elements which are supporting the main elements of the both circuits, which are not presented in the drawing.

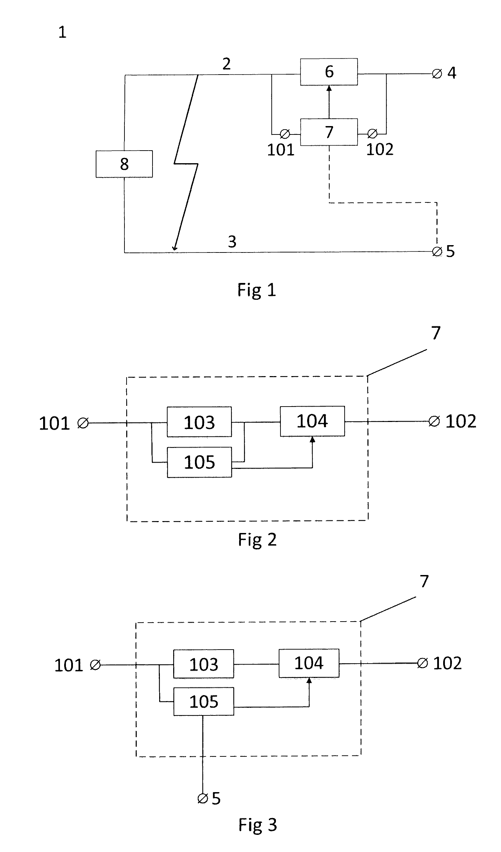

In the second embodiment of the invention the measuring and control circuit 105 is connected in parallel between the overhead line 2 and the ground line 3 so the test device 7 has an electrical connection with the connection terminal 5 of the external mains, what is presented in figure 1 by dashed line. The measuring and control circuit 105 is connected to the terminal 101 and connection terminal 5 is able to trigger the impulse generator circuit 104. The capacitor circuit 103 is designed for limiting the current entering the catenary line 1 system during the test. The capacitor circuit 103 comprises a capacitor as a main element for limiting the current entering the catenary line 1 system during the test. The capacitor circuit 103 comprises at least one capacitor or capacitor banks having the capacitance of a value C', calculated according to the formulae:

$$C' = \frac{I}{j2\pi f U} \qquad (2)$$

where:

I - is a value of current entering the catenary line system (1) from the external mains,
U - is a magnitude of AC voltage between connecting terminals (4) and (5),
f - is a frequency of the external mains.

The impulse generator circuit 104 is design for enabling to flow the current into the catenary line 1 system for only a half of the period of an electrical impulse. The circuit 104 comprises solid-state means for enabling the current for flowing into the catenary line 1 for only the half of the period, such as a thyristor as a main element for carried out the function. The measuring and control circuit 105 comprises of solid-state means for processing the measured voltage between terminals 101 and 5 so that it obtains a signal with indication the state of the overhead line 2.
An experimental test for the first embodiment of the invention was performed for:

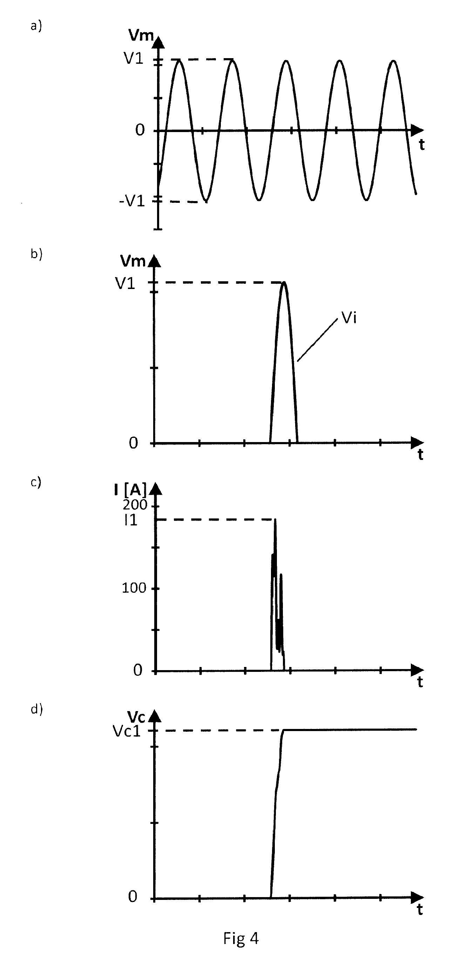

A) when a short circuit is present at the catenary line system (fig.4). The main circuit breaker 6 is open and between connection terminals 4 and 5 a voltage of mains Vm is present, what is presented in fig.4 a). The impulse generator circuit 104 is generating an impulse Vi which impulse is causing the flow of current I through the capacitor circuit 103, flowing into the overhead line 2, through connected in parallel the load 8 and short circuit, and next through rails to the return line 3. The resultant impedance of the load 8 and the short circuit is low in comparison to the impedance of the load 8 alone. In case of current I flows, when the resultant impedance is low, the Joule's integral value is raising rapidly. The capacitor C of the capacitor circuit 103 will limit the current. After this test, in presence of short circuit, the voltage Vc at the capacitor inside the capacitor circuit 103 has the value Vc1 which is equal to the maximum value V1 of the voltage Vm of mains. The magnitude I1 of the current I, shown in fig.4 c), is not limited by capacitor circuit 103, thus during short circuit the magnitude is high what means that the ability of self-clearing in case of transient short circuit is saved.

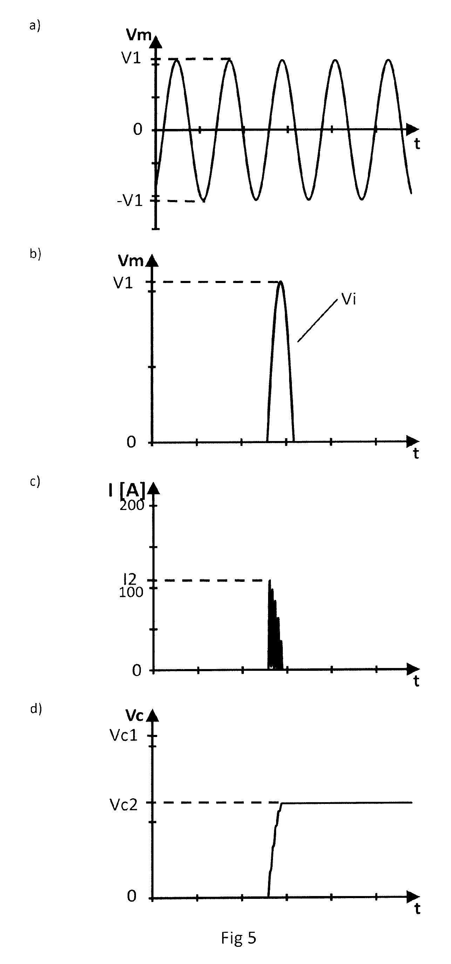

B) when a short circuit is not present at the catenary line system, and the catenary line system is healthy (fig.5).

The main circuit breaker 6 is open and between connection terminals 4 and 5 the voltage of mains Vm is present, what is presented in fig.5 a). The circuit 104 is generating an impulse Vi which impulse is causing the flow of current I through the circuit 103, flowing into the overhead line 2 and through the load 8 and through rails and return line 3. The impedance of load 8 causes slow rise of the Joule's integral value. The influence of the capacitor of the circuit 103 on the Joule's integral will be limited. After this test, with healthy line, the voltage Vc at the capacitor inside the circuit 103 will have the value Vc2 which is smaller than the value Vc1 being equal to the maximum value of the voltage of mains V1. The magnitude I2 of the current I, shown in fig.5 c), is not limited by capacitor circuit 103.

Comparison of the result of the experimental test:

If voltage Vc at capacitor inside circuit 103 has reached the value Vc1 presented on the diagram 4d), where Vc1 value is equal to the value V1 being the maximum value of the voltage of mains Vm presented on the diagram 4a), the catenary line system 1 is short circuited, and circuit breaker 6 will not make - case A.
If the voltage Vc at capacitor inside circuit 103 has a value Vc2 which is smaller than the value Vc1 being equal to the maximum value of the voltage of mains V1, which is presented in figure 5d) and 5a) the catenary line system 1 is healthy, and the circuit breaker 6 will make - case B.
In case A the magnitude of the current I1 is high, what means is equal to I1 value, thus the ability of self-clearing in case of transient short circuit is saved. In case B the magnitude of the current I2 is lower, what means is equal to I2 value. No short circuit is detected.
The device according to the invention enables to detect which case A or B is present at the catenary line system 1.
An experimental test for the second embodiment of the invention was performed for:

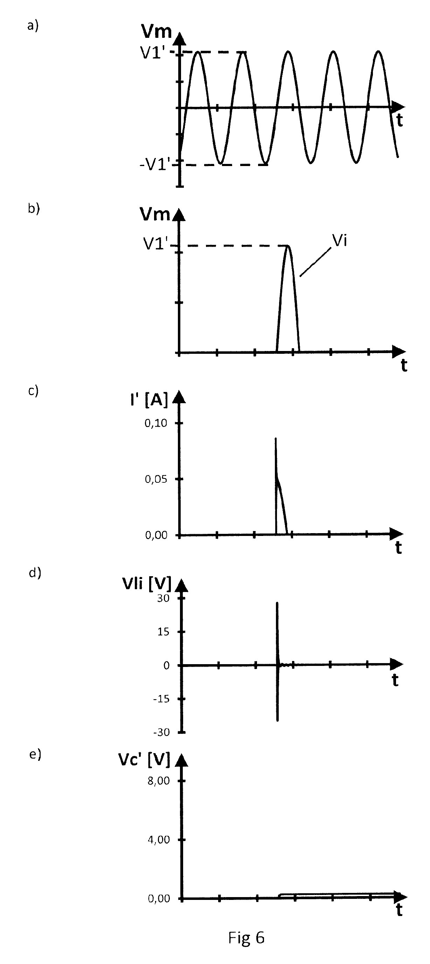

A) when a short circuit is present at the catenary line system (fig.6). The main circuit breaker 6 is open and between connection terminals 4 and 5 a voltage of mains Vm is present, what is presented in fig.6 a). The impulse generator circuit 104 is generating an impulse Vi which causes the flow of current I' through the capacitor circuit 103, flowing into the overhead line 2, through connected in parallel the load 8 and short circuit, and next through rails to the return line 3. The resultant impedance of the load 8 and the short circuit is negligible in comparison to high impedance of the capacitor circuit 103. The capacitor C' of the capacitor circuit 103 will limit the value of the current I' entering the catenary line system as depicted in fig.6 c). The tiny current I' flowing through the catenary line will generate the low voltage response as depicted in fig.6 d). The measuring and control circuit 105 comprises solid-state means for processing the measured voltage between terminals 101 and 5 so that it obtains a signal with indication the state of the overhead line. After this test, in presence of short circuit, the voltage Vc' at the capacitor inside the measuring and control circuit 105 has negligible value as shown in fig.6 e).

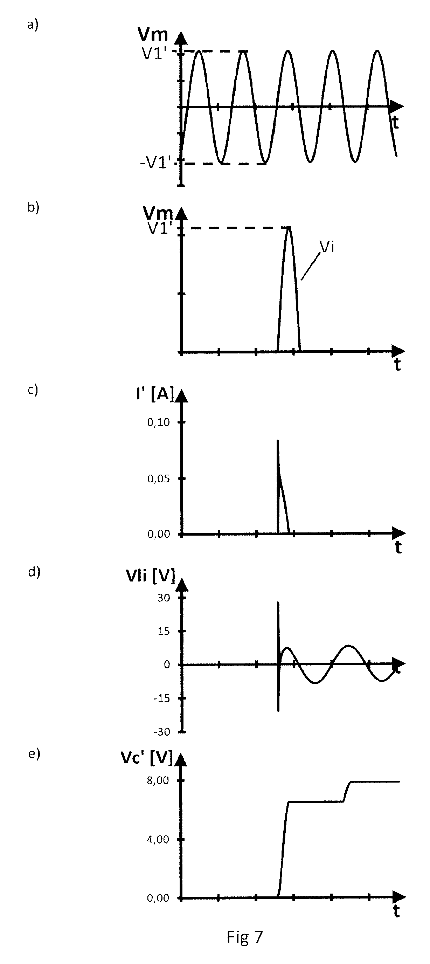

B) when a short circuit is not present at the catenary line system, and the catenary line system is healthy (fig.7).

The main circuit breaker 6 is open and between connection terminals 4 and 5 a voltage of mains Vm is present, what is presented in fig.7 a). The impulse generator circuit 104 is generating an impulse Vi which causes the flow of current I' through the capacitor circuit 103, flowing into the overhead line 2, through the load 8, and next through rails to the return line 3. The impedance of the load 8 is negligible in comparison to high impedance of the capacitor circuit 103. The capacitor C' of the capacitor circuit 103 will limit the value of the current I' entering the catenary line system 1, as depicted in fig.7 c). The tiny current I' flowing through the catenary line system 1 will generate the low voltage response as depicted in fig.7 d). The measuring and control circuit 105 comprises solid-state means for processing the measured voltage between terminals 101 and 5 so that it obtains a signal with indication the state of the line. After this test at the healthy line, the voltage Vc' at the capacitor inside the measuring and control circuit 105 has a positive value as shown in fig.7 e).

Comparison of the result of the experimental test:

If voltage Vc' at capacitor inside the measuring and control circuit 105 has a negligible value like presented on the diagram 6 e), the catenary line system 1 is short circuited, and circuit breaker 6 will not make - case A.

If the voltage Vc' at capacitor inside the measuring and control circuit 105 has a positive value like presented on the diagram 7 e) the catenary line system 1 is healthy, and the circuit breaker 6 will make - case B.

The device according to the invention enables to detect which case A or B is present at the catenary line system 1.

**Claims**

1. A catenary line test device (7) for a main circuit breaker (6) of an AC catenary line system (1), powered through connecting terminals first (4) and second (5) where the main circuit breaker (6) is connected to the overhead line (2) and a load (8) is connected between the overhead line (2) and a return grounding line (3), and to the main circuit breaker (6) the test device (7) is in parallel connected through the terminals (101) and (102); the catenary line test device (7) is adapted to prevent of closing the main circuit breaker (6) on short-circuited overhead line (2), **characterized in that** the test device (7) comprises a capacitor circuit (103) and an impulse generator circuit (104) connected in series to the capacitor circuit (103) and a measuring and control circuit (105) is connected for providing a half period of an electrical impulse generated in the impulse generator circuit (104), causes the flow of the supply current into the catenary line system (1) through the first connecting terminal (4).

2. A catenary test device according to claim 1, **characterized in that** the measuring and control circuit (105) is connected in parallel with the capacitor circuit (103) and the capacitor circuit (103) comprises at least one capacitor or capacitor banks having the value C, calculated according to the formulae:

$$C = \frac{2W}{U^2}$$

where:

W -is a maximum energy entering to the catenary line system (1) from the external mains,
U - is a magnitude of AC voltage between connecting terminals (4) and (5).

3. A catenary test device according to claim 1, **characterized in that** the measuring and control circuit (105) is connected in parallel between the overhead line (2) and the ground line (3) in such a way that the test device (7) has an electrical connection with the second connecting terminal (5) of the external mains; the capacitor circuit (103) comprises a capacitor or capacitor banks as a main element for limiting the current entering the catenary line (1) system having the capacitance of a value C', calculated according to the formulae:

$$C' = \frac{I}{2\pi f U}$$

where:

I - is a value of current entering the catenary line system (1) from the external mains,
U - is a magnitude of AC voltage between connecting terminals (4) and (5),
f - is a frequency of the external mains.

4. A catenary test device (7) according to claims 1-3, **characterized in that** the impulse generator circuit (104) is equipped with solid- state means for generating a half period long electrical impulse having at

**EP 3 301 460 A1**

least one thyristor.

Fig 1

Fig 2

Fig 3

Fig 4

a)

b)

c)

d)

Fig 5

a)

Vm

V1'

-V1'

t

b)

Vm

V1'

Vi

t

c)

I' [A]

0,10

0,05

0,00

t

d)

Vli [V]

30

15

0

-15

-30

t

e)

Vc' [V]

8,00

4,00

0,00

t

Fig 6

a)

b)

c)

d)

e)

Fig 7

Europäisches
Patentamt

European
Patent Office

Office européen
des brevets

# EUROPEAN SEARCH REPORT

Application Number

EP 16 46 0073

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 345 180 A (MAIER REINHARD [DE] ET AL) 6 September 1994 (1994-09-06)<br>* figures 1-2, 3c *<br>* column 1, lines 9-16 *<br>* column 1, lines 65-68 *<br>* column 2, line 56 - column 3, line 26 *<br>* column 3, lines 48-66 *<br>* column 4, lines 27-34 *<br>* column 4, lines 43-60 *<br>----- | 1-4 | INV.<br>G01R19/165<br>G01R31/02<br>G01R31/08<br><br>ADD.<br>G01R31/327<br>H02H3/08<br>H02H7/26<br>H02H11/00 |
| X | FR 2 947 058 A1 (SCHNEIDER ELECTRIC IND SAS [FR]) 24 December 2010 (2010-12-24)<br>* page 4, line 20 - page 5, line 31 *<br>* page 7, line 28 - page 8, line 6 *<br>* figures 1A, 1B, 3 *<br>----- | 1-4 | |
| X | US 2008/024142 A1 (OPFER JOHN C [US] ET AL) 31 January 2008 (2008-01-31)<br>* paragraphs [0020] - [0022] *<br>* paragraphs [0024] - [0027] *<br>* paragraphs [0032] - [0035] *<br>* paragraph [0037] *<br>* paragraphs [0040], [0044] *<br>* paragraph [0048] *<br>* paragraph [0050] *<br>* paragraphs [0062] - [0064] *<br>* figures 1-7, 13, 14 *<br>----- | 1-4 | TECHNICAL FIELDS SEARCHED (IPC)<br><br>G01R<br>H02H |
| A | WO 2010/112083 A1 (ENEL DISTRIBUZIONE SPA [IT]; VERONI FABIO [IT]) 7 October 2010 (2010-10-07)<br>* page 2 *<br>* page 8 *<br>* page 12 *<br>* pages 14-15 *<br>* figure 3a *<br>----- | 1-4 | |

-/--

The present search report has been drawn up for all claims

| Place of search | Date of completion of the search | Examiner |
|---|---|---|
| Munich | 14 March 2017 | Danisi, Alessandro |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

Europäisches
Patentamt

European
Patent Office

Office européen
des brevets

## EUROPEAN SEARCH REPORT

Application Number

EP 16 46 0073

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2012/218676 A1 (DEMETRIADES GEORGIOS [SE] ET AL) 30 August 2012 (2012-08-30)<br>* paragraph [0047] *<br>* figure 3 *<br>----- | 1-4 | |
| A | GB 1 162 811 A (LONDON ELECTRICITY BOARD [GB]; ALBERT JEFFERIES BAGGOTT) 27 August 1969 (1969-08-27)<br>* the whole document *<br>----- | 1-3 | |

TECHNICAL FIELDS
SEARCHED      (IPC)

The present search report has been drawn up for all claims

| Place of search | Date of completion of the search | Examiner |
|---|---|---|
| Munich | 14 March 2017 | Danisi, Alessandro |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 16 46 0073

This annex lists the patent family members relating to the patent documents cited in the above-mentioned European search report.
The members are as contained in the European Patent Office EDP file on
The European Patent Office is in no way liable for these particulars which are merely given for the purpose of information.

14-03-2017

| Patent document cited in search report | | Publication date | Patent family member(s) | | Publication date |
|---|---|---|---|---|---|
| US 5345180 | A | 06-09-1994 | EP 0563695 A2<br>US 5345180 A | | 06-10-1993<br>06-09-1994 |
| FR 2947058 | A1 | 24-12-2010 | EP 2443716 A1<br>FR 2947058 A1<br>WO 2010146248 A1 | | 25-04-2012<br>24-12-2010<br>23-12-2010 |
| US 2008024142 | A1 | 31-01-2008 | NONE | | |
| WO 2010112083 | A1 | 07-10-2010 | DK 2415138 T3<br>EP 2415138 A1<br>ES 2523495 T3<br>HR P20140889 T1<br>PE 07742010 A1<br>PT 2415138 E<br>SI 2415138 T1<br>TW 201042867 A<br>WO 2010112083 A1 | | 29-09-2014<br>08-02-2012<br>26-11-2014<br>19-12-2014<br>29-11-2010<br>24-09-2014<br>28-11-2014<br>01-12-2010<br>07-10-2010 |
| US 2012218676 | A1 | 30-08-2012 | CN 102696087 A<br>EP 2489053 A1<br>US 2012218676 A1<br>WO 2011044928 A1 | | 26-09-2012<br>22-08-2012<br>30-08-2012<br>21-04-2011 |
| GB 1162811 | A | 27-08-1969 | NONE | | |

EPO FORM P0459

For more details about this annex : see Official Journal of the European Patent Office, No. 12/82

**EP 3 301 460 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1855120 A